(19) Europäisches Patentamt
European Patent Office
Office européen des brevets

(11) **EP 3 309 599 A1**

(12) **DEMANDE DE BREVET EUROPEEN**

(43) Date de publication:
**18.04.2018 Bulletin 2018/16**

(51) Int Cl.:
***G02B 26/08*** (2006.01)        ***H01L 41/04*** (2006.01)
***H01L 41/09*** (2006.01)

(21) Numéro de dépôt: **17196077.6**

(22) Date de dépôt: **12.10.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **13.10.2016 FR 1659908**

(71) Demandeur: **Commissariat à l'Energie Atomique et aux Energies Alternatives**
**75015 Paris (FR)**

(72) Inventeur: **DURAND, Gilles**
**78120 RAMBOUILLET (FR)**

(74) Mandataire: **Cabinet Camus Lebkiri**
**25 rue de Maubeuge**
**75009 Paris (FR)**

(54) **PROCEDE ET DISPOSITIF DE CORRECTION DES DEFORMATIONS D'UNE SURFACE ET MIROIR UTILISANT LEDIT PROCEDE ET/OU LEDIT DISPOSITIF**

(57)     Un aspect de l'invention concerne un procédé de correction des déformations de la surface d'un objet équipé d'un dispositif de correction des déformations, ledit dispositif de correction comportant une couche piézoélectrique comprenant une première surface et une deuxième surface, une première pluralité de pistes électriques disposée sur la première surface de la couche piézoélectrique, une deuxième pluralité de pistes électriques disposée sur la deuxième surface de la couche piézoélectrique, les pistes de la première pluralité formant une pluralité de lignes et les pistes de la deuxième pluralité formant une pluralité de colonnes, chaque colonne de la pluralité de colonnes étant perpendiculaires aux lignes de la pluralité de lignes, le croisement d'une ligne et d'une colonne formant un pixel. Le procédé selon l'invention comprend une première étape de mesure des déformations de la surface à corriger ; une deuxième étape d'identification des pixels nécessaires à la correction desdites déformations ; une troisième étape d'application pour chaque pixel identifié, par l'intermédiaire de la ligne et de la colonne correspondant audit pixel, d'un champ électrique supérieur au champ coercitif du matériau piézoélectrique de la couche piézoélectrique.

Fig. 6

EP 3 309 599 A1

**Description**

DOMAINE TECHNIQUE DE L'INVENTION

Le domaine technique de l'invention est celui de la correction des déformations d'une surface d'un objet. La présente invention concerne un procédé de correction des déformations d'une surface d'un objet et en particulier un procédé de correction utilisant le phénomène de rémanence piézoélectrique. La présente invention concerne également un dispositif de correction des déformations d'une surface d'un objet ainsi qu'un miroir équipé d'un tel dispositif. Enfin, la présente invention concerne l'utilisation d'un dispositif objet de l'invention pour la mise en oeuvre d'un procédé objet de l'invention.

ARRIERE-PLAN TECHNOLOGIQUE DE L'INVENTION

Les miroirs de télescope se doivent d'être construits avec une grande précision afin de pouvoir garantir une bonne qualité de l'image obtenue. La précision requise est en général de l'ordre du vingtième de longueur d'onde. De manière générale, les grands télescopes se présentent sous la forme d'une pluralité de miroirs de plus petite taille. Par exemple, il est courant d'avoir recours à des segments de miroir de 2 m. Pour de tels miroirs, la précision est donc de l'ordre de quelques nanomètres c'est-à-dire huit ordres de grandeur en dessous de la taille du segment de miroir proprement dit. La réalisation de segments de miroirs avec une telle précision requiert la succession de nombreuses étapes comprenant notamment la stabilisation, l'usinage de préforme, de nombreuses étapes de polissage et de mesures. En outre, lorsque ces miroirs sont utilisés à froid, il devient indispensable d'inclure des cycles cryogéniques de stabilisation et de mesure. Bien entendu, l'ensemble de ces étapes conduit à une grande complexité de fabrication ainsi qu'à un coût élevé et produit des miroirs ayant une masse élevée.

Afin de s'affranchir de ces procédés de fabrication complexes, une technique de réalisation de miroirs composites obtenus par réplique a été mise au point.

Cependant, les miroirs obtenus par cette technique présentent des défauts de déformation du fait des contraintes qui apparaissent au moment de la polymérisation des résines et des différences de température entre la fabrication et l'utilisation.

Il est donc connu de rectifier ces erreurs de déformation à l'aide d'actionneurs situés sur une des surface du miroir à corriger. Il est notamment connu d'utiliser des actionneurs à base de matériaux piézoélectriques. Pour cela, on réalise une plaque en matériau piézoélectrique sur laquelle on vient disposer sur chacune des surfaces des électrodes afin de définir une pluralité de lignes sur une première surface et une pluralités de colonnes sur une deuxième surface opposée à la première, les lignes étant, en général, perpendiculaire aux colonnes. Un pixel est ainsi défini à chaque croisement entre une ligne et une colonne. Autrement dit, une plaque comportant 10 lignes et 10 colonnes permet de réaliser 100 pixels. La correction s'effectue en trois étapes principales. Tout d'abord, une mesure optique est effectuée sur le miroir afin d'identifier les déformations dudit miroir. Ensuite, une étape d'identification des pixels à actionner afin de corriger les déformations mesurées est effectuée. Enfin, une étape d'application d'un champ permettant la déformation des pixels identifiés lors de l'étape précédente est réalisée.

Un exemple de réalisation d'un tel système est détaillé dans l'article « Thin Deformable Mirrors for a Reconfigurable Space Aperture », 53rd AIAA/ASME/ASCE/AHS/ASC Structures, Structural Dynamics, and Materials Conférence (2012). Dans ce document, l'application du champ électrique se fait en deux temps. Tout d'abord, une première phase de cycle est appliquée sur l'ensemble des pixels durant laquelle le champ électrique est amené à plusieurs reprises au-dessus du champ coercitif du matériau piézoélectrique utilisé. Cette première étape de cycle permet d'obtenir une déformation pour chaque pixel qui varie linéairement en fonction du champ électrique appliqué. Lors de la deuxième phase, chaque pixel identifié se voit appliquer le champ électrique nécessaire. Cette technique présente l'avantage de faciliter le calcul du champ électrique nécessaire à la correction en faisant en sorte d'obtenir une réponse en champ électrique quasiment linéaire. En revanche, la correction nécessite l'application d'un champ électrique en permanence ce qui n'est pas sans poser de problème lorsque l'on souhaite minimiser la consommation électrique d'un télescope ou bien encore éviter un échauffement de ce dernier par effet joule.

Il existe donc un besoin d'un système de correction des déformations qui permet d'obtenir une correction des déformations de manière durable sans nécessiter l'application d'un champ électrique de manière continue.

RESUME DE L'INVENTION

L'invention offre une solution aux problèmes évoqués précédemment, en tirant avantage de la rémanence des matériaux piézo-électriques de sorte à obtenir une correction qui perdure même lorsqu'aucun champ électrique n'est appliqué au niveau des différents pixels.

Un premier aspect de l'invention concerne une procédé de correction des déformations de la surface d'un objet équipé d'un dispositif de correction des déformations, ledit dispositif de correction comportant une couche piézoélectrique comprenant une première surface et une deuxième surface, une première pluralité de pistes électriques disposée sur la première surface de la couche piézoélectrique, une deuxième pluralité de pistes électriques disposée sur la deuxième surface de la couche piézoélectrique, les pistes de la première pluralité formant une pluralité de lignes et les pistes de la deuxième pluralité formant une pluralité de colonnes, chaque colonne de la pluralité de colonnes croisant les lignes de la pluralité de lignes, le croisement d'une ligne et d'une colonne formant un pixel. Le procédé selon l'invention comprend :

- une première étape de mesure des déformations de la surface à corriger ;
- une deuxième étape d'identification des pixels nécessaires à la correction desdites déformations ;
- une troisième étape d'application pour chaque pixel identifié, par l'intermédiaire de la ligne et de la colonne correspondant audit pixel, d'un champ électrique supérieur au champ coercitif du matériau piézoélectrique de la couche piézoélectrique.

Grâce à l'invention, une fois que le champ électrique a été appliqué une première fois, la courbure locale de l'objet au niveau du pixel est modifiée par effet bilame entre ledit objet et le matériau piézoélectrique et une déformation persiste au niveau des pixels sélectionnés même lorsque ce champ électrique n'est plus présent. L'invention tire parti du phénomène de rémanence, c'est-à-dire la propriété qu'à un matériau piézoélectrique de conserver une déformation lorsque ce dernier a été exposé à un champ électrique supérieur au champ coercitif, et cela même si plus aucun champ électrique n'est appliqué audit matériau. Cette déformation peut être de l'ordre de 0.5% à 1% pour un cristal piézoélectrique libre mais varie en fonction de la rigidité de la surface à corriger. A l'issue du procédé, les déformations sont corrigées par la déformation des pixels sur lesquels a été appliqué un champ magnétique au-delà du champ coercitif et ce de manière permanente. Ainsi, la correction ne nécessite plus d'alimentation en énergie une fois le procédé selon l'invention appliqué. Ceci contraste avec les procédés de l'état de l'art qui n'utilisent pas de manière directe la rémanence et dans lesquels seul un champ électrique en-dessous du champ coercitif est appliqué. Une alimentation en énergie est donc nécessaire en permanence afin de maintenir ledit champ électrique.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Avantageusement, la troisième étape comprend en outre l'application, pour au moins un pixel non identifié, d'un champ électrique inférieure au champ coercitif.

Avantageusement, le champ électrique appliqué sur chaque pixel identifié est obtenu par l'application d'une tension $\frac{2U}{3}$ sur la ligne correspondant audit pixel et d'une tension $-\frac{2U}{3}$ sur la colonne correspondant audit pixel, les autres lignes de la pluralité de lignes et les autres colonnes de la pluralité de colonnes étant maintenues à une tension nulle, U étant la tension produisant un champ électrique égal au champ coercitif lorsqu'elle est appliquée entre la ligne et la colonne correspondant audit pixel. Ainsi on s'assure que seuls les pixels identifiés sont soumis à un champ électrique supérieur au champ coercitif. Dans ce cas, le champ électrique vu par les pixels adressés est deux fois plus élevé que le champ vu par les pixels non adressés.

Avantageusement, de manière alternative, le champ électrique appliqué sur chaque pixel identifié est obtenu par l'application d'une tension $\frac{3U}{4}$ sur la ligne correspondant audit pixel et d'une tension $-\frac{3U}{4}$ sur la colonne correspondant audit pixel, les autres lignes de la pluralité de lignes étant maintenues à une tension de $-\frac{U}{4}$ et les autres colonnes de la pluralité de colonnes étant maintenues à une tension de $\frac{U}{4}$, U étant la tension produisant un champ électrique égal au champ coercitif lorsqu'elle est appliquée entre la ligne et la colonne correspondant audit pixel. Dans ce cas, le champ électrique vu par les pixels adressés est trois fois plus élevé que le champ vu par les pixels non adressés. Ainsi, la fuite de polarisation entre pixels (cross-talk en anglais) est réduite.

Avantageusement, le procédé selon un premier aspect de l'invention comporte une étape d'application, sur les pixels identifiés, d'un champ alternatif inférieur au champ coercitif et supérieur au champ électrique appliqué aux pixels non identifiés. Cette étape permet de stabiliser la polarisation des pixels identifiés.

Avantageusement, le procédé comprend une étape d'application, sur au moins un des pixels, d'un champ électrique alternatif d'une amplitude décroissante depuis une valeur supérieure au champ coercitif jusqu'à une valeur telle que la polarisation du pixel soit inférieure à un seuil prédéterminé. Ainsi, on s'assure que le pixel est dépolarisé.

Avantageusement, le procédé comprend une étape d'application, sur au moins un pixel initialement polarisé par l'application d'un champ électrique supérieure au champ coercitif dans une première direction, d'un champ électrique ayant une deuxième direction opposée à la première direction et une valeur absolue supérieure au champ coercitif.

Un deuxième aspect de l'invention concerne un dispositif de correction des déformations de la surface d'un objet comportant une couche piézoélectrique comprenant une première surface et une deuxième surface, une première pluralité de pistes électriques disposée sur la première surface de la couche piézoélectrique, une deuxième pluralité de pistes électriques disposée sur la deuxième surface de la couche piézoélectrique, les pistes de la première pluralité formant une pluralité de lignes et les pistes de la deuxième pluralité formant une pluralité de colonnes croisant les lignes de la pluralité de lignes, le croisement d'une ligne et d'une colonne formant un pixel. De plus, le nombre de colonnes est égal à k × r avec k et r deux entiers strictement positifs et chaque colonne a un indice $i \in [1, k \times r]$, la piste formant la colonne d'indice $i = \alpha k + m$ avec $\propto$ un entier appartenant à [0, r[ et m un entier appartenant à [1, k] ayant une largeur $L_m$ telle que $L_m = 2^{m-1}L_1$ avec $L_1$ la largeur des pistes associées aux colonnes d'indice $i = \alpha k + 1$.

Ainsi, il est possible de moduler la déformation en jouant sur la surface des pixels du dispositif de correction par l'intermédiaire de la largeur des colonnes. Autrement dit, même lorsque la déformation de chaque pixel ne peut prendre que deux valeurs, il est possible de moduler la correction en jouant sur la surface des pixels du dispositif.

Outre les caractéristiques qui viennent d'être évoquées dans le paragraphe précédent, le dispositif selon un deuxième aspect de l'invention peut présenter une ou plusieurs caractéristiques complémentaires parmi les suivantes, considérées individuellement ou selon toutes les combinaisons techniquement possibles.

Avantageusement, le nombre de lignes est égal à k' × r' avec k' et r' deux entiers strictement positifs, chaque ligne ayant un indice $j \in [1, k' \times r']$ et la piste formant la ligne d'indice $j = \beta k' + n$ avec $\beta$ un entier appartenant à [0, r'[ et n un entier appartenant à [1, k'] ayant une largeur $L'_n$ telle que $L'_n = (2^k)^{n-1}L'_1$ avec $L'_1$ la largeur des pistes associées aux lignes d'indice $j = \beta k' + 1$.

Ainsi, la surface des pixels est modulée par la largeur des colonnes mais également par la largeur des lignes.

Avantageusement, la couche piézoélectrique comprend au moins un ensemble de trois bandes chaque bande dudit ensemble présentant une direction d'anisotropie de déformation distincte des directions d'anisotropie de déformation des deux autres bandes de l'ensemble, chaque bande étant disposée en regard d'une ligne de la pluralité de lignes.

Avantageusement, la direction d'anisotropie de déformation d'une bande de l'ensemble est choisie comme direction d'anisotropie de déformation de référence et les directions d'anisotropie de déformation des deux autres bandes de l'ensemble font un angle de 60° ou -60° avec ladite direction de référence.

Ainsi, il est également possible de prendre en compte l'anisotropie de déformation en associant à chaque pixel une anisotropie de déformation parmi les trois anisotropies de déformation définies par les bandes.

Avantageusement, le dispositif de correction comprend un système de chauffage configuré pour chauffer tout ou partie des pixels.

Ainsi, lorsque le dispositif est opéré à basse température, par exemple dans l'espace où la température de l'environnement peut être inférieure à 50 K, il est possible de chauffer les pixels afin de faciliter la modification de la polarisation de ces derniers.

Un troisième aspect de l'invention concerne un miroir équipé d'un dispositif de correction selon un deuxième aspect de l'invention.

Un quatrième aspect de l'invention concerne l'utilisation d'un dispositif selon un deuxième aspect de l'invention pour la mise en oeuvre du procédé selon un premier aspect de l'invention.

L'invention et ses différentes applications seront mieux comprises à la lecture de la description qui suit et à l'examen des figures qui l'accompagnent.

BREVE DESCRIPTION DES FIGURES

Les figures sont présentées à titre indicatif et nullement limitatif de l'invention.

- La figure 1 montre un ordinogramme d'un premier mode de réalisation d'un procédé de correction des déformations selon un premier aspect de l'invention.
- Les figures 2A et 2B montrent une représentation schématique d'un dispositif de correction susceptible d'être utilisé dans le procédé selon un premier aspect de l'invention.
- La figure 3A montre une configuration en calotte sphérique selon un mode de réalisation de l'invention.
- La figure 3B montre une configuration en nid d'abeille selon un mode de réalisation de l'invention.
- La figure 4 montre une représentation schématique des tensions de polarisation des pixels dans un mode de réalisation d'un procédé selon un premier aspect de l'invention.
- La figure 5 montre une représentation schématique des tensions de polarisation des pixels dans un mode de réalisation alternatif d'un procédé selon un premier aspect de l'invention.
- La figure 6 montre une représentation schématique d'un premier mode de réalisation d'un dispositif de correction selon un deuxième aspect de l'invention.

- La figure 7 montre une représentation schématique d'un deuxième mode de réalisation d'un dispositif de correction selon un deuxième aspect de l'invention.
- La figure 8 montre une représentation schématique d'un troisième mode de réalisation d'un dispositif de correction selon un deuxième aspect de l'invention.
- La figure 9 montre une représentation schématique d'un quatrième mode de réalisation d'un dispositif de correction selon un deuxième aspect de l'invention.

DESCRIPTION DETAILLEE D'AU MOINS UN MODE DE REALISATION DE L'INVENTION

Sauf précision contraire, un même élément apparaissant sur des figures différentes présente une référence unique.

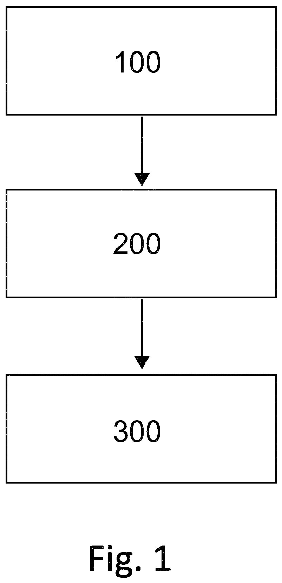

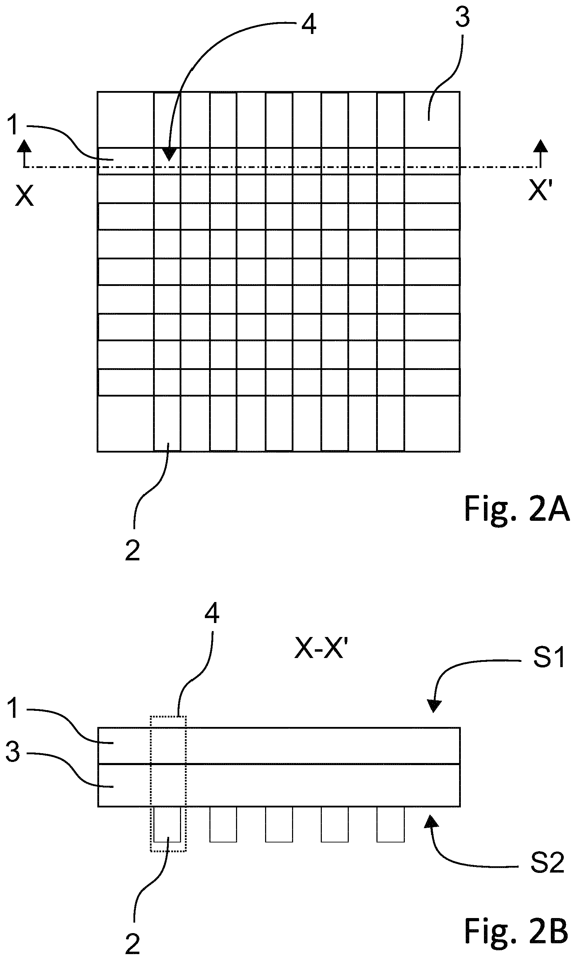

Un premier mode de réalisation d'un procédé de correction des déformations selon un premier aspect de l'invention est illustré dans la figure 1. Le procédé de correction des déformations vise à corriger la déformation de la surface d'un objet. Pour ce faire, l'objet est équipé d'un dispositif de correction des déformations illustré aux figures 2A et 2B. Le dispositif de correction comporte une couche piézoélectrique 3 comprenant une première surface S1 et une deuxième surface S2, une première pluralité de pistes électriques 1 disposée sur la première surface S1 de la couche piézoélectrique 3, une deuxième pluralité de pistes électriques 2 disposée sur la deuxième surface S2 de la couche piézoélectrique 3. De plus, les pistes 1 de la première pluralité forment une pluralité de lignes 1 et les pistes 2 de la deuxième pluralité forment une pluralité de colonnes 2, chaque colonne 2 de la pluralité de colonnes croisant les lignes 1 de la pluralité de lignes, le croisement d'une ligne 1 et d'une colonne 2 formant un pixel 4. Comme détaillé sur les figures 2A et 2B, le pixel 4 (matérialisé par des pointillés sur la figure 2B) est défini par le croisement d'une ligne 1 et d'une colonne 2 et comprend la partie de la colonne 2 en regard avec la ligne 1, la partie de la ligne 1 en regard avec la colonne 2 et la partie de la couche piézoélectrique 3 située entre la partie de ligne et la partie de colonne appartenant audit pixel.

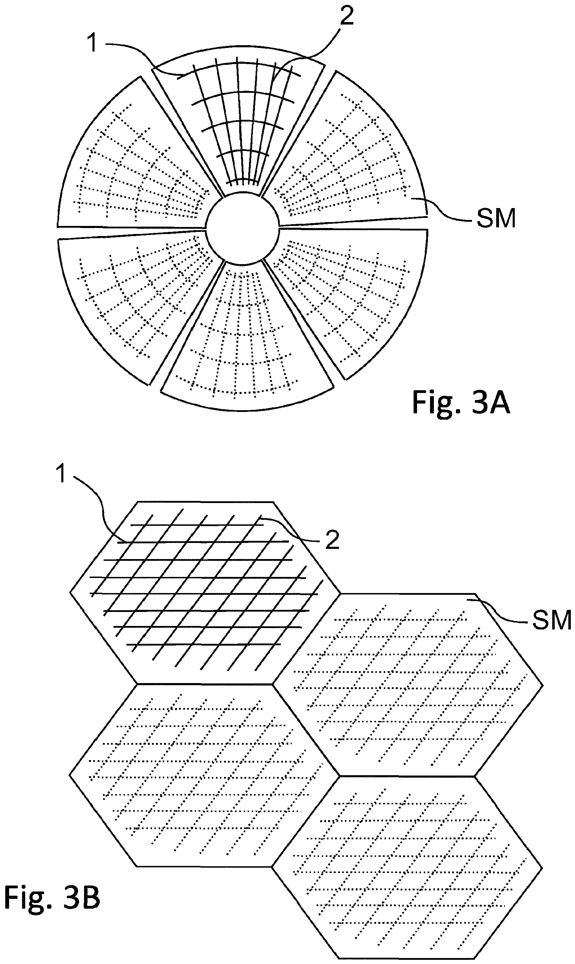

Sur la figure 2A, les lignes 1 et les colonnes 2 se croisent en formant un angle droit mais tout angle peut être envisagé. Par exemple les lignes 1 peuvent former des cercles concentriques et les colonnes 2 s'étendre de manière radiale par rapport à ces lignes 1. Une telle configuration est illustrée à la figure 3A dans le cas d'un miroir à calotte sphérique. Un tel miroir se compose de secteurs de miroir SM, les secteurs de miroir SM étant assemblés de sorte à former un disque. Dans un autre exemple, les lignes 1 forment un angle non nul, constant et différent d'un angle droit avec les colonnes 2. Une telle configuration est illustrée à la figure 3B dans le cas d'un miroir en nid d'abeille. Un tel miroir se compose de sections de miroir SM de forme losange similaire à la forme d'une alvéole de nid d'abeille. Les lignes 1 et les colonnes 2 se croisent de sorte que les lignes 1 soient parallèles à au moins un premier côté du losange et les colonnes 2 soient parallèles à un deuxième côté du losange différent du premier côté.

Le procédé selon un premier mode de réalisation comprend une première étape 100 de mesure des déformations de la surface à corriger. Cette première étape 100 peut notamment être effectuée à l'aide d'une méthode optique. D'autres méthodes peuvent cependant être envisagées en fonction de la nature de la surface à corriger, par exemple à l'aide d'un palpeur mécanique ou à l'aide d'une pointe à effet de champ (mesure sans contact).

Le procédé comprend également une deuxième étape 200 d'identification des pixels nécessaires à la correction desdites déformations. Cette deuxième étape 200 peut notamment être effectuée par calcul numérique, par exemple par calcul par éléments finis.

Le procédé comprend en outre une troisième étape d'application 300 pour chaque pixel identifié, par l'intermédiaire de la ligne et de la colonne correspondant audit pixel, d'un champ électrique supérieur au champ coercitif du matériau piézoélectrique de la couche piézoélectrique.

Dans un premier exemple de réalisation, l'objet consiste en un miroir plat de forme carrée et de 50mm de côté. Le dispositif de correction comporte une couche de piézoélectrique d'une épaisseur de 0,2mm et le matériau piézoélectrique composant ladite couche est un matériau piézoélectrique de type Pi255. La couche de piézoélectrique présente sur chacune de ces faces trois pistes électriques, les pistes électriques de la première face croisant les pistes électriques de la deuxième face de sorte à former neuf pixels. Afin d'obtenir ces pistes électriques, il est par exemple possible de déposer une couche métallique sur chacune des faces de la couche piézoélectrique puis de procéder à une étape de gravure afin de venir constituer lesdites pistes électriques. Le champ électrique coercitif du matériau piézoélectrique étant de 1100 V/mm et l'épaisseur de la couche piézoélectrique étant de 0,2mm, il est nécessaire d'appliquer une tension supérieure à 220 V entre une ligne et une colonne pour obtenir un champ électrique supérieur au champ coercitif au niveau du pixel ainsi adressé. Afin de fixer le dispositif de correction au miroir, une lame de verre-borax de la marque Pyrex ayant une épaisseur de 0.7mm au préalable aluminisée sur la face avant du miroir est collée à l'aide d'époxy et à température ambiante au dispositif de correction.

Dans cet exemple de réalisation, l'étape 100 de mesure des déformations de la surface à corriger, ici la surface du miroir, est effectuée à l'aide d'une méthode de projection de franges et de mesure de la déflection desdites franges.

Cette méthode présente l'avantage d'être facilement mise en oeuvre. Cependant, on peut également faire appel à une méthode de mesure par interférométrie ou diversité des phases, même si ces méthodes sont plus complexes à mettre en oeuvre.

L'étape 200 d'identification des pixels nécessaire à la correction des déformations est effectuée par une méthode de calcul par éléments finis. Elle est suivie d'une étape 300 d'application, pour chaque pixel identifié et par l'intermédiaire de la ligne et de la colonne correspondant audit pixel, d'un champ électrique supérieur au champ coercitif du matériau piézoélectrique de la couche piézoélectrique. La tension à appliquer afin d'obtenir un champ supérieur au champ coercitif doit être supérieure à 220V. Cependant, seuls les pixels identifiés doivent être exposés à un tel champ. La polarisation d'un pixel est donc obtenu par l'application d'une tension de -150V sur la ligne correspondant audit pixel tandis qu'une tension de +50V est appliquée sur les autres lignes. De manière similaire, une tension de +150V est appliquée sur la colonne correspondant au pixel alors qu'une tension égale à -50V est appliquée sur les autres colonnes. Le pixel ainsi adressé est donc polarisé par une tension de 300V suffisante pour produire un champ électrique supérieur au champ coercitif. Les pixels qui ont une ligne ou une colonne en commun avec le pixel adressé sont exposés à une tension de +/-100V insuffisante pour produire un champ électrique supérieur au champ coercitif et donc pour polariser lesdits pixels. Enfin, les autres pixels sont quant à eux exposés par une tension de +100V. Autrement dit, seul le pixel adressé est polarisé. Le même schéma d'adressage est donc appliqué pour chacun des pixels identifiés.

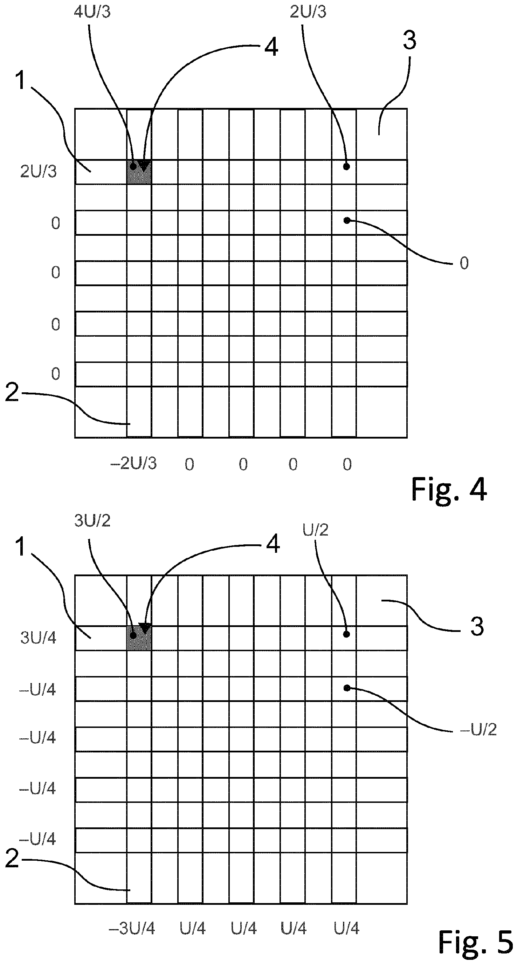

Dans un mode de réalisation illustré à la figure 4, le champ électrique appliqué sur chaque pixel 4 identifié (grisé sur la figure) est obtenu par l'application d'une tension $\frac{2U}{3}$ sur la ligne correspondant audit pixel 4 et d'une tension $-\frac{2U}{3}$ sur la colonne correspondant audit pixel 4, U étant la tension produisant un champ électrique égal au champ coercitif lorsqu'elle est appliquée entre la ligne et la colonne correspondant audit pixel 4 (elle dépend donc de la nature du matériau de la couche du piézoélectrique et de l'épaisseur de ladite couche). Ainsi, chaque pixel 4 que l'on souhaite polariser peut être sélectionné à l'aide d'une ligne 1 et d'une colonne 2 et se voir ainsi appliquer un champ électrique supérieur au champ coercitif. Les autres lignes de la pluralité de lignes et les autres colonnes de la pluralité de colonnes sont quant à elles maintenues à une tension nulle. Autrement dit, durant la phase de polarisation, seul le pixel 4 sélectionné est exposé à un champ électrique au-dessus du champ coercitif. En effet, les pixels 4 ayant en commun avec le pixel sélectionné une ligne 1 ou une colonne 2 ne se voient appliquer qu'une tension égale à $\frac{2U}{3}$ et donc un champ électrique en dessous du champ coercitif. Cependant, les tensions utilisées dans cette méthode de polarisation des pixels 4 peuvent donner lieu à des fuites de polarisations entre pixels 4 (cross-talk en anglais).

Afin de diminuer les fuites de polarisation, dans un mode de réalisation alternatif illustré à la figure 5, le champ électrique appliqué sur chaque pixel 4 identifié est obtenu par l'application d'une tension $\frac{3U}{4}$ sur la ligne 1 correspondant audit pixel et d'une tension $-\frac{3U}{4}$ sur la colonne 2 correspondant audit pixel 4, les autres lignes de la pluralité de lignes étant maintenues à une tension de $-\frac{U}{4}$ et les autres colonnes de la pluralité de colonnes étant maintenues à une tension de $\frac{U}{4}$. Le champ électrique est donc au-dessus du champ coercitif sur le pixel sélectionné. De plus, la tension au niveau des autres pixels n'est que de $\left|\frac{U}{2}\right|$ et le champ électrique au niveau de ces pixels est en dessous du champ coercitif.

Dans un mode de réalisation, la polarisation des pixels identifiés s'effectue en adressant lesdits pixels ligne par ligne. Plus particulièrement, l'adressage s'effectue de la manière suivante pour chaque ligne :

- polarisation de la ligne à une tension de $\frac{3U}{4}$, les autres lignes étant polarisée à une tension de $-\frac{U}{4}$ ;

- polarisation des colonnes relatives aux pixels identifié correspondant à ladite ligne à une tension de $-\frac{3U}{4}$, les autres colonnes étant polarisées à une tension de $\frac{U}{4}$.

Dans un mode de réalisation, une fois le pixel polarisé, ce dernier se voit appliqué un champ alternatif inférieur au champ coercitif et supérieur au champ électrique appliqué aux pixels non identifiés. Cette étape permet de stabiliser la polarisation du pixel concerné. Par exemple, dans un mode de réalisation, le champ électrique alternatif est égal à 80% de la valeur du champ coercitif. Comme exposé dans les deux méthodes d'adressage précédentes, le champ électrique appliqué aux pixels non identifié est au maximum égal à 50% du champ coercitif. Autrement dit, lorsque l'on utilise une des deux méthodes d'adressage précédemment décrites, un champ de 80% du champ coercitif est inférieur au champ coercitif et supérieur au champ électrique appliqué aux pixels non identifiés et convient donc à la stabilisation des pixels polarisés.

Avant d'effectuer une mesure de la déformation de la surface de l'objet à corriger, il peut être important de s'assurer que cette déformation n'est pas induite par une rémanence déjà présente dans au moins un pixel de la pluralité de pixels du dispositif de correction des déformations de la surface d'un objet. Pour cela, il peut être nécessaire d'effectuer une étape de dépolarisation des pixels. De façon analogue, après une première polarisation, si la correction de la déformation n'est pas satisfaisante, il peut être nécessaire d'annuler la polarisation de l'un des pixels polarisés. A cette fin, dans un mode de réalisation, le procédé selon un premier aspect de l'invention comprend une étape d'application, sur au moins un pixel, d'un champ alternatif d'amplitude décroissante depuis une valeur supérieure à celle du champ coercitif jusqu'à une valeur telle que la polarisation du pixel soit inférieure à un seuil prédéterminé. Dans un mode de réalisation, l'ensemble des pixels est soumis à ce champ alternatif.

Dans un mode de réalisation, le ou les pixels sont dépolarisés à l'aide d'une méthode telle que décrite dans le document « Fatigue and rétention properties of shape memory piezoelectric actuator with non-180° domain switching », Smart Materials and Structures, 21 (2012). Pour cela, un champ de direction opposé au champ appliqué initialement pour polariser le pixel que l'on cherche à dépolarisé et de valeur absolue légèrement supérieure au champ coercitif est appliqué sur ledit pixel. Autrement dit, lorsque l'on cherche à dépolariser un pixel initialement polarisé par l'application d'un champ électrique supérieure au champ coercitif dans une première direction, on applique audit pixel un champ électrique ayant une deuxième direction opposée à la première direction et une valeur absolue supérieure au champ coercitif.

Comme expliqué précédemment, dans le procédé selon l'invention, la déformation est réalisée par l'application d'un champ électrique au-dessus du champ coercitif qui vient polariser le ou les pixels 4. Pour un pixel donné, la déformation ne peut pas être modulée mais se fait en « tout ou rien ». Autrement dit, un pixel 4 ne peut se trouver que dans deux configurations :

- sans déformation lorsqu'aucun champ électrique supérieur au champ coercitif n'a pas été appliqué au niveau du pixel 4 ou que ce dernier a été dépolarisé; et
- déformé lorsqu'un champ électrique supérieur au champ coercitif a été appliqué au niveau du pixel 4 et que ce dernier est donc polarisé.

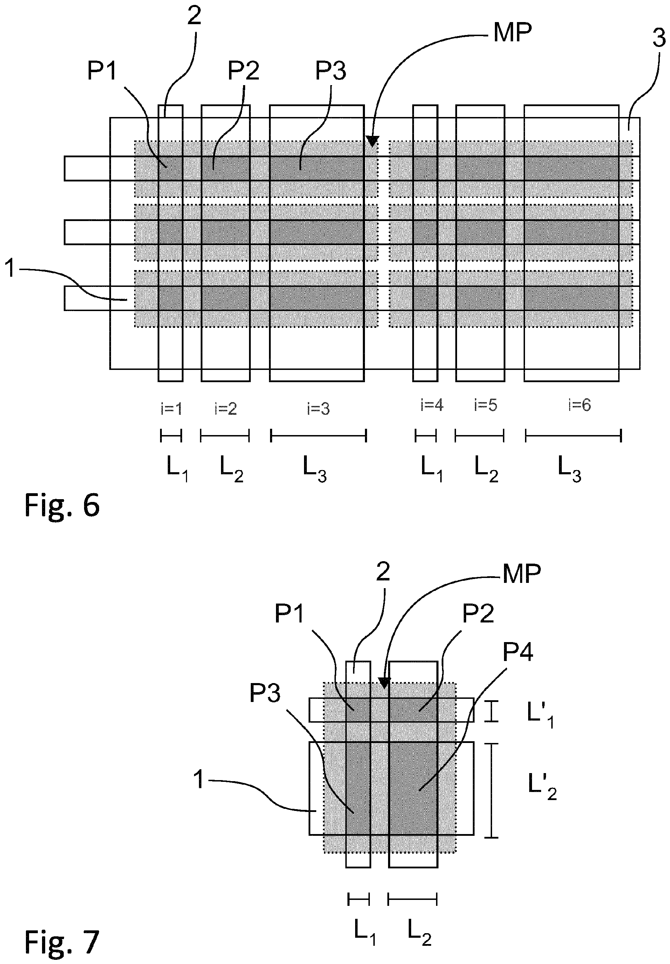

Il peut cependant être intéressant de pouvoir moduler cette déformation en fonction des besoins. Pour cela, un dispositif de correction selon un mode de réalisation d'un deuxième aspect de l'invention est illustré à la figure 6. Le dispositif de correction des déformations comporte une couche piézoélectrique 3 comprenant une première surface S1 et une deuxième surface S2, une première pluralité de pistes électriques 1 disposée sur la première surface S1 de la couche piézoélectrique 3, une deuxième pluralité 2 de pistes électriques disposée sur la deuxième surface S2 de la couche piézoélectrique 3, les pistes de la première pluralité 1 formant une pluralité de lignes 1 et les pistes de la deuxième pluralité 2 formant une pluralité de colonnes 2 croisant les lignes de la pluralité de lignes 1, le croisement d'une ligne 1 et d'une colonne 2 formant un pixel 4 (grisé sombre sur la figure 6).

Le dispositif de correction comporte en outre un nombre de colonnes 2 égal à $k \times r$ avec $k$ et $r$ deux entiers strictement positifs et chaque colonne a un indice $i \in [1, k \times r]$. De plus, la piste formant la colonne 2 d'indice $i = \alpha k + m$ avec $\alpha$ un entier appartenant à $[0, r[$ et $m$ un entier appartenant à $[1, k]$ a une largeur $L_m$ telle que $L_m = 2^{m-1}L_1$ avec $L_1$ la largeur des pistes associées aux colonnes 2 d'indice $i = \alpha_k + 1$. Dans l'exemple de réalisation de la figure 6, le dispositif comporte trois lignes et le nombre de colonnes est tel que $r = 2$ et $k = 3$. Comme illustré à la figure 6, le dispositif comporte donc six colonnes ayant chacun un indice **i** allant de 1 à 6. Plus particulièrement, les indices sont comme suit :

- i = 1 avec $\alpha$ = 0 et m = 1 ;

- i = 2 avec $\alpha$ = 0 et m = 2 ;

- i = 3 avec $\alpha$ = 0 et m = 3 ;

- i = 4 avec $\alpha$ = 1 et m = 1 ;

- i = 5 avec $\alpha$ = 1 et m = 2 ;

- i = 6 avec $\alpha$ = 1 et m = 3 ;

Les pistes relatives aux colonnes 2 d'indice **i = 1, 4 (m = 1)** ont une première largeur $L_1$, les pistes relatives aux colonnes 2 d'indice **i = 2, 5 (m = 2)** ont une deuxième largeur $L_2 = 2L1$ et les pistes relatives aux colonnes 2 d'indice **i = 3,6 (m = 3)** ont une troisième largeur $L_3 = 2^2 L_1$. On obtient ainsi une série de 12 pixels 4. Plus particulièrement, on obtient six macro-pixels MP (grisés clair sur la figure 6) formés chacun par un premier pixel P1, un deuxième pixel P2 et un troisième pixel P3, lesdits pixels ayant chacun une surface différente. En considérant la surface du premier pixel P1 comme la surface unitaire, la surface du premier pixel P1 est égale 1, la surface du deuxième pixel P2 est égale à 2 et la surface du troisième pixel P3 est égale à 4. La déformation d'un pixel 4 étant proportionnelle à sa surface, le macro-pixel MP peut donc adopter les déformations énumérées dans le tableau 1.

Tableau 1

| Valeur de la déformation | 0 | 1 | 2 | 3 | 4 | 5 | 6 | 7 |
|---|---|---|---|---|---|---|---|---|
| Pixel(s) à polariser | Ø | P1 | P2 | P1, P2 | P3 | P1, P3 | P2, P3 | P1, P2, P3 |

Ainsi, en choisissant de ne polariser qu'un pixel ou plusieurs pixels d'un macro-pixel MP, il est donc possible de moduler la déformation. Autrement dit, bien que la déformation se fasse en « tout ou rien » au niveau d'un pixel unique, cette dernière peut être modulée au niveau d'un macro-pixel MP en utilisant un codage similaire au codage binaire. On comprend donc que le dispositif illustré à la figure 6 est particulièrement adapté à la mise en oeuvre d'un procédé selon un premier aspect de l'invention.

Il est bien sûr possible d'appliquer le même principe au niveau des lignes et de définir des macro-pixels MP plus complexes s'étendant sur plusieurs lignes et/ou sur plusieurs colonnes, le principe restant le même : obtenir des pixels d'un même macro-pixel dont la surface croit en puissance de 2. Pour cela, dans un mode de réalisation illustré à la figure 7, le nombre de lignes est égal à **k' $\times$ r'** avec **k'** et **r'** deux entiers strictement positifs. De plus, chaque ligne a un indice **j** $\in$ **[1, k' $\times$ r']** et la piste formant la ligne d'indice **j = $\beta$k' + n** avec $\beta$ un entier appartenant à **[0, r'[** et **n** un entier appartenant à **[1, k']** a une largeur **L'$_n$** telle que **L'$_n$ = $(2^k)^{n-1}$L'$_1$** avec **L'$_1$** la largeur des pistes associées aux lignes d'indice **j = $\beta$k' + 1**. Dans l'exemple de réalisation de la figure 7 (cette figure ne fait apparaitre qu'un macro-pixel mais un dispositif selon l'invention peut en comprendre plusieurs), les colonnes sont choisies de sorte que **k = 2** et les lignes sont choisies de sorte que **k' = 2**. On a donc deux largeurs possibles pour les colonnes (**L$_1$** et **L$_2$ = 2L$_1$**) et deux largeurs possibles pour les lignes (**L'$_1$** et **L'$_2$ = $(2^2)$L'$_1$ = 4L'$_1$**). Le premier pixel P1 a une surface de **L$_1$ $\times$ L'$_1$**, le deuxième pixel P2 a une surface de **2L$_1$ $\times$ L'$_1$**; le troisième pixel P3 à une surface de **L$_1$ $\times$ 4L'$_1$** et le quatrième pixel P4 à une surface de **2L$_1$ $\times$ 4L'$_1$**. De la même manière que précédemment, en choisissant la surface du premier pixel P1 comme surface unitaire et sachant que la déformation d'un pixel 4 est proportionnelle à sa surface, le macro-pixel MP peut donc adopter les déformations énumérées dans le tableau 2.

| Valeur de la déformation | 0 | 1 | 2 | 3 | 4 | 5 | 6 | 7 |
|---|---|---|---|---|---|---|---|---|
| Pixel(s) à polariser | Ø | P1 | P2 | P1, P2 | P3 | P1, P3 | P2, P3 | P1, P2, P3 |

| Valeur de la déformation | 8 | 9 | 10 | 11 | 12 | 13 | 14 | 15 |
|---|---|---|---|---|---|---|---|---|
| Pixel(s) à polariser | P4 | P4, P1 | P4, P2 | P4, P1, P2 | P3, P4 | P1, P3, P4 | P2, P3, P4 | P1, P2, P3, P4 |

Tableau 2

Ce mode de réalisation illustre comment la déformation d'un macro-pixel MP peut être modulée en utilisant de manière coordonnée la largeur des lignes 1 et des colonnes 2 de sorte à mettre en place un codage binaire de la surface des pixels 4. Les deux modes de réalisation précédents, s'ils permettent de traiter le problème de modulation de la déformation, ne permettent pas en revanche de prendre en compte les problèmes liés aux déformations anisotropes. Ces problèmes se posent notamment lorsque le matériau utilisé pour la construction de la surface à corriger comporte des fibres. C'est notamment le cas lorsque lors la correction des déformations concerne des miroirs réalisés par réplique.

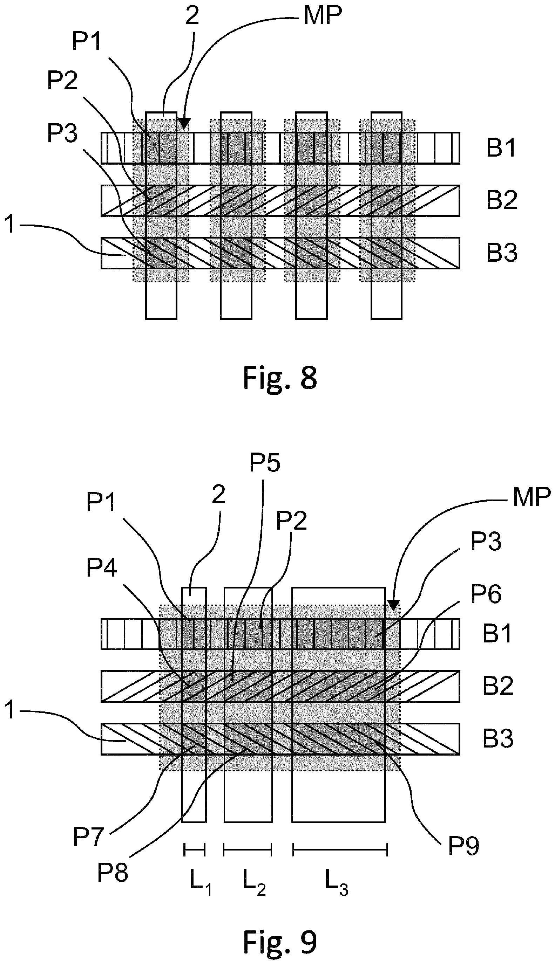

Afin de résoudre au moins en partie ce problème, dans un mode de réalisation la couche piézoélectrique 3 comprend au moins un ensemble de trois bandes, chaque bande de l'ensemble présentant une direction d'anisotropie de déformation distincte des directions d'anisotropie des autres bandes dudit ensemble. Dans un exemple de réalisation illustré à la figure 8, la couche piézoélectrique comprend une première bande B1, une deuxième bande B2 et une troisième bande B3. La direction d'anisotropie de déformation d'une des bandes, ici la première bande B1, est choisie comme direction d'anisotropie de déformation de référence et les autres directions d'anisotropie de déformation font un angle de 60°ou -60° avec ladite direction de référence. De plus, chaque bande de la pluralité de bandes est disposée en regard d'une ligne de la pluralité de lignes 1. Autrement dit, à chaque ligne 1 correspond une bande et à chaque bande correspond une ligne 1. Les bandes peuvent être obtenues en utilisant des plaques piézoélectriques striées ou en ayant recours à des fibres piézoélectriques, l'orientation de l'anisotropie de déformation étant alors donnée par l'orientation des stries ou l'orientation des fibres. Dans le schéma de la figure 8 (cette figure fait apparaitre quatre macro-pixels mais un dispositif selon l'invention peut en comprendre un nombre plus petit ou plus grand), le macro-pixel MP est composé d'un premier pixel P1 ayant une première anisotropie de déformation A1 à 0°, d'un deuxième pixel P2 ayant une deuxième anisotropie de déformation A2 à 60° et d'un troisième pixel P3 ayant une troisième anisotropie de déformation A3 à -60°. Le macro-pixel MP ainsi obtenu permet de sélectionner l'anisotropie de la déformation parmi la première A1, la deuxième A2 ou la troisième A3 anisotropie de déformation en sélectionnant le pixel correspondant.

Il peut cependant être avantageux de pouvoir moduler la déformation associée à chaque anisotropie de déformation. Pour cela, dans un mode de réalisation illustré à la figure 9 (cette figure ne fait apparaitre qu'un macro-pixel mais un dispositif selon l'invention peut en comprendre plusieurs), le codage des niveaux de déformation par la largeur des colonnes est utilisé conjointement avec la configuration de la couche piézoélectrique en bandes piézoélectrique. Le macro-pixel ainsi obtenu comprend un premier P1, un deuxième P2, un troisième P3, un quatrième P4, un cinquième P5, un sixième P6, un septième P7, un huitième P8 et un neuvième P9 pixel et permet de moduler la déformation pour chaque anisotropie de déformation. Plus particulièrement, les premier P1, deuxième P2 et troisième P3 pixels associés à la première anisotropie de déformation A1 (0°) ont des surfaces respectives de 1, 2 et 4 (la surface du pixel P1 étant choisie comme surface unitaire). La déformation du macro-pixel MP associée à la première anisotropie de déformation A1 peut donc prendre les valeurs énumérées dans le tableau 3.

Tableau 3

| Valeur de la déformation | 0 | 1 | 2 | 3 | 4 | 5 | 6 | 7 |
|---|---|---|---|---|---|---|---|---|
| Pixels à polariser | Ø | P1 | P2 | P1, P2 | P3 | P1, P3 | P2, P3 | P1, P2, P3 |

Il en est de même des déformations associées à la deuxième anisotropie de déformation A2 (60°) au moyen des quatrième P4, cinquième P5 et sixième P6 pixels et à la troisième anisotropie de déformation A3 (-60°) au moyen des septième P7, huitième P8 et neuvième P9 pixels.

Les modes de réalisation selon le deuxième aspect de l'invention font apparaitre de manière évidente comment, à partir d'une modulation « tout ou rien » et en créant des bandes d'anisotropies différentes en regard de chaque ligne, il est possible d'obtenir un dispositif de correction des erreurs avec lequel on peut non seulement moduler la déformation et l'anisotropie de cette dernière mais en outre pour laquelle aucun source d'énergie n'est nécessaire une fois que les corrections ont été apportées.

Une application possible du dispositif de correction selon l'invention concerne les applications infrarouges pour lesquelles les miroirs à corriger doivent fonctionner à basse température. Ceci s'applique entre autre pour les miroirs spatiaux qui sont refroidis radiativement aux alentours de 50 K. Or, lorsque la température du miroir et donc des matériaux piézo-électriques du dispositif de correction est basse, par exemple inférieure à 180 K, il devient plus difficile de faire basculer la polarisation par l'application d'un champ électrique. Ceci présente l'avantage de « geler » la polarisation et la contrainte dans le matériau qui ne présente plus de dérive de polarisation ni de forme dans le temps mais rend la mise en oeuvre du dispositif de correction plus difficile. Afin de répondre à la difficulté que peuvent constituer les basses températures, dans un mode de réalisation, le dispositif de correction comprend un système de chauffage configuré pour chauffer tout ou partie des pixels. La gamme de température compatible avec l'établissement de la polarisation rémanente dépend des matériaux piézoélectrique et se situe préférentiellement dans la gamme de -50°C à +100°C. Le système de chauffage peut prendre la forme d'un film résistif collé sur chaque pixel entre deux films isolants et parcouru par un courant transverse. Dans un mode de réalisation préférentiel, la puissance par unité de surface est appliquée à l'aide du système de chauffage en contrôlant la température moyenne des pixels de façon à les réchauffer jusqu'à atteindre une température compatible avec la modification de la polarisation rémanente (par exemple au-dessus de 220K). Dans un mode de réalisation, la régulation de la puissance par unité de surface appliquée à l'aide du système de chauffage est réalisée à l'aide d'un asservissement local de la température des pixels. La température ainsi obtenue est de préférence maintenue pendant toute la durée du procédé de correction des déformations. Le chauffage peut se faire à l'échelle du dispositif ou bien localement, de manière sélective, sur un ou plusieurs pixels.

**Revendications**

1. Procédé de correction des déformations de la surface d'un objet équipé d'un dispositif de correction des déformations, ledit dispositif de correction comportant une couche piézoélectrique (3) comprenant une première surface (S1) et une deuxième surface (S2), une première pluralité de pistes électriques disposée sur la première surface (S1) de la couche piézoélectrique, une deuxième pluralité de pistes électriques disposée sur la deuxième surface (S2) de la couche piézoélectrique, les pistes de la première pluralité formant une pluralité de lignes (1) et les pistes de la deuxième pluralité formant une pluralité de colonnes (2), chaque colonne de la pluralité de colonnes croisant les lignes de la pluralité de lignes, le croisement d'une ligne et d'une colonne formant un pixel (4) ; ledit procédé étant **caractérisé en ce qu'**il comprend :

   - une première étape (100) de mesure des déformations de la surface à corriger ;
   - une deuxième étape (200) d'identification des pixels nécessaires à la correction desdites déformations ;
   - une troisième étape (300) d'application pour chaque pixel (4) identifié, par l'intermédiaire de la ligne (1) et de la colonne (2) correspondant audit pixel (4), d'un champ électrique supérieur au champ coercitif du matériau piézoélectrique de la couche piézoélectrique (3).

2. Procédé selon la revendication précédente **caractérisé en ce que** la troisième étape comprend l'application, pour au moins un pixel non identifié, d'un champ électrique inférieure au champ coercitif.

3. Procédé selon l'une des revendications précédentes **caractérisé en ce que** le champ électrique appliqué sur chaque pixel (4) identifié est obtenu par l'application d'une tension $\dfrac{2U}{3}$ sur la ligne (1) correspondant audit pixel (4) et d'une tension $-\dfrac{2U}{3}$ sur la colonne (2) correspondant audit pixel (4), les autre lignes de la pluralité de ligne et les autres colonnes de la pluralité de colonnes étant maintenues à une tension nulle, U étant la tension produisant un champ électrique égal au champ coercitif lorsqu'elle est appliquée entre la ligne (1) et la colonne (2) correspondant audit pixel (4).

4. Procédé selon la revendication 1 ou la revendication 2 **caractérisé en ce que** le champ électrique appliqué sur chaque pixel (4) identifié est obtenu par l'application d'une tension $\dfrac{3U}{4}$ sur la ligne (1) correspondant audit pixel (4) et d'une tension $-\dfrac{3U}{4}$ sur la colonne (2) correspondant audit pixel (4), les autres lignes de la pluralité de lignes étant maintenues à une tension de $-\dfrac{U}{4}$ et les autres colonnes de la pluralité de colonnes étant maintenues à une tension de $\dfrac{U}{4}$, U étant la tension produisant un champ électrique égal au champ coercitif lorsqu'elle est appliquée entre la ligne (1) et la colonne (2) correspondant audit pixel (4).

5. Procédé selon l'une des revendications précédentes **caractérisé en ce qu'**il comporte une étape d'application, sur les pixel (4) identifiés, d'un champ alternatif inférieur au champ coercitif et supérieur au champ électrique appliqué aux pixels (4) non identifiés.

6. Procédé selon l'une des revendications précédentes **caractérisé en ce qu'**il comprend l'application, sur au moins un des pixels (4), d'un champ électrique alternatif d'une amplitude décroissante depuis une valeur supérieure à celle du champ coercitif jusqu'à une valeur telle que la polarisation du au moins un pixel (4) soit inférieure à un seuil prédéterminé.

7. Procédé selon l'une des revendications précédentes **caractérisé en ce qu'**il comprend une étape d'application, sur au moins un pixel initialement polarisé par l'application d'un champ électrique supérieure au champ coercitif dans une première direction, d'un champ électrique ayant une deuxième direction opposée à la première direction et une valeur absolue supérieure au champ coercitif.

8. Procédé selon l'une des revendications précédentes **caractérisé en ce que** l'objet est un miroir et que la surface à corriger est la surface réfléchissante dudit miroir.

9. Dispositif de correction des déformations de la surface d'un objet comportant une couche piézoélectrique (3) comprenant une première surface (S1) et une deuxième surface (S2), une première pluralité de pistes électriques disposée sur la première surface (S1) de la couche piézoélectrique (3), une deuxième pluralité de pistes électriques disposée sur la deuxième surface (S2) de la couche piézoélectrique (3), les pistes de la première pluralité formant une pluralité de lignes (1) et les pistes de la deuxième pluralité formant une pluralité de colonnes (2) croisant les lignes de la pluralité de lignes, le croisement d'une ligne et d'une colonne formant un pixel (4) ; ledit dispositif étant **caractérisé en ce que** le nombre de colonnes est égal à $k \times r$ avec k et r deux entiers strictement positifs, **en ce que** chaque colonne a un indice $i \in [1, k \times r]$ et **en ce que** la piste formant la colonne d'indice $i = \alpha k + m$ avec $\alpha$ un entier appartenant à $[0, r[$ et m un entier appartenant à $[1, k]$ a une largeur $L_m$ telle que $L_m = 2^{m-1}L_1$ avec $L_1$ la largeur des pistes associées aux colonnes d'indice $i = \alpha k + 1$, de manière à pouvoir moduler la déformation en jouant sur la surface des pixels du dispositif de correction par l'intermédiaire de la largeur des colonnes.

10. Dispositif selon la revendication précédente **caractérisé en ce que** le nombre de lignes est égal à $k' \times r'$ avec k' et r' deux entiers strictement positifs, **en ce que** chaque ligne a un indice $j \in [1, k' \times r']$ et **en ce que** la piste formant la ligne d'indice $j = \beta k' + n$ avec $\beta$ un entier appartenant à $[0, r'[$ et n un entier appartenant à $[1, k']$ a une largeur $L'_n$ telle que $L'_n = (2^k)^{n-1}L'_1$ avec $L'_1$ la largeur des pistes associées aux lignes d'indice $j = \beta k' + 1$.

11. Dispositif selon l'une des deux revendications précédente **caractérisé en ce que** la couche piézoélectrique (3) comprend au moins un ensemble de trois bandes (B1,B2,B3), chaque bande dudit ensemble présentant une direction d'anisotropie de déformation distincte des directions d'anisotropie de déformation des deux autres bandes dudit ensemble, chaque bande étant disposée en regard d'une ligne (1) de la pluralité de lignes.

12. Dispositif selon la revendication précédente **caractérisé en ce que** la direction d'anisotropie de déformation de l'une des bandes (B1) de l'ensemble est choisie comme direction d'anisotropie de déformation de référence, les directions d'anisotropie de déformation des deux autres bandes (B2,B3) dudit l'ensemble faisant un angle de 60°ou -60° avec ladite direction de référence.

13. Dispositif selon l'une des revendications 9 à 12 **caractérisé en ce qu'**il comprend un système de chauffage configuré pour chauffer les pixels.

14. Miroir **caractérisé en ce qu'**il est équipé d'un dispositif de correction selon l'une des revendications 9 à 13.

15. Utilisation d'un dispositif selon l'une des revendications 9 à 13 pour la mise en oeuvre du procédé selon l'une des revendications 1 à 8.

Fig. 1

4

3

1

X

X'

**Fig. 2A**

2

4

X-X'

S1

1

3

2

S2

**Fig. 2B**

Fig. 3A

Fig. 3B

Fig. 4

Fig. 5

Fig. 6

Fig. 7

Fig. 8

Fig. 9

Europäisches
Patentamt

European
Patent Office

Office européen
des brevets

**RAPPORT DE RECHERCHE EUROPEENNE**

Numéro de la demande

EP 17 19 6077

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 2 199 836 A1 (BAE SYSTEMS PLC [GB]) 23 juin 2010 (2010-06-23) | 9,10,14 | INV. G02B26/08 |
| Y | * alinéas [0021] - [0023], [0025], [0033], [0037], [0041]; figures 1,9 * | 1-3,8, 13,15 | H01L41/04 H01L41/09 |
| | ----- | | |
| Y | CA 639 128 A (JADERHOLM HENRIK W) 3 avril 1962 (1962-04-03) * page 7, lignes 4-12; revendications 2,6; figures 5,6 * * page 8, ligne 7 - page 9, ligne 30 * | 1-3,8, 13,15 | |
| | ----- | | |
| A | US 2006/152830 A1 (FARAH JOHN [US]) 13 juillet 2006 (2006-07-13) * alinéas [0009], [0011], [0028]; figures 1,2 * | 9-15 | |
| | ----- | | |

| | | | DOMAINES TECHNIQUES RECHERCHES (IPC) |
|---|---|---|---|
| | | | G02B H01L |

Le présent rapport a été établi pour toutes les revendications

| Lieu de la recherche | Date d'achèvement de la recherche | Examinateur |
|---|---|---|
| Munich | 2 février 2018 | Casse, Martin |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 17 19 6077

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-02-2018

| Document brevet cité au rapport de recherche | Date de publication | Membre(s) de la famille de brevet(s) | Date de publication |
|---|---|---|---|
| EP 2199836 A1 | 23-06-2010 | AUCUN | |
| CA 639128 A | 03-04-1962 | AUCUN | |
| US 2006152830 A1 | 13-07-2006 | US 2006152830 A1<br>US 2009109560 A1 | 13-07-2006<br>30-04-2009 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- Thin Deformable Mirrors for a Reconfigurable Space Aperture. *53rd AIAA/ASME/ASCE/AHS/ASC Structures, Structural Dynamics, and Materials Conférence,* 2012

- Fatigue and rétention properties of shape memory piezoelectric actuator with non-180° domain switching. *Smart Materials and Structures,* 2012, vol. 21